# EUROPEAN PATENT APPLICATION

(11) **EP 3 565 015 A1**
(43) Date of publication of application: **06.11.2019**
(21) Application number: 17886687.7
(22) Date of filing: 29.11.2017
(51) Int. Cl.: H01L 51/44

(54) **SOLAR CELL, LIGHT-ABSORBING LAYER, AND METHOD FOR FORMING LIGHT-ABSORBING LAYER**

(30) Priority: 28.12.2016 JP 2016255432
(71) Applicant: Panasonic Intellectual Property Management Co., Ltd., Osaka-shi, Osaka 540-6207 (JP)
(72) Inventor: UCHIDA, Ryuusuke, Osaka-shi, Osaka 540-6207 (JP); SUZUKA, Michio, Osaka-shi, Osaka 540-6207 (JP)
(74) Representative: Grünecker Patent- und Rechtsanwälte PartG mbB
(86) International application number: PCT/JP2017/042714
(87) International publication number: WO 2018/123402

(57) **Abstract**

A solar cell comprises a first electrode, a second electrode opposite to the first electrode, and a photoabsorber layer located between the first electrode and the second electrode and including a first layer and a second layer. The first layer contains a first compound which has a perovskite structure represented by the composition formula A¹M¹X¹₃, where A¹ is a monovalent cation, M¹ is a divalent cation, and X¹ is a halogen anion. The second layer contains a second compound which has a perovskite structure represented by the composition formula A²M²X²₃, where A² is a monovalent cation, M² is a divalent cation, and X² is a halogen anion, and has a different composition from the first compound. At least one of the first compound in the first layer and the second compound in the second layer has a single orientation.

## Description

### BACKGROUND

### 1. Technical Field

The present disclosure relates to a solar cell, a photoabsorber layer, and a formation method of the photoabsorber layer. Hereinafter, the solar cell includes what is called a perovskite solar cell.

### 2. Description of the Related Art

A solar cell using a compound having a perovskite crystal structure represented by the composition formula AMX₃ and a crystal structure similar thereto as a photoabsorbing material has been recently researched and developed. Hereinafter, "a perovskite crystal structure represented by the composition formula AMX₃ and a crystal structure similar thereto" is referred to as "perovskite compound".

A solar cell using the perovskite compound has a stacking structure including two electrodes disposed opposite to each other and a photoabsorber layer disposed therebetween and in which light is absorbed and photoelectric charge is separated. Hereinafter, "a solar cell using the perovskite compound" is referred to as "a perovskite solar cell". The photoabsorber layer includes a perovskite compound. Hereinafter, "a layer including the perovskite compound" is referred to as "a perovskite layer". As a perovskite compound, for example, the compound represented by CH₃NH₃PbI₃ is used.

In addition, Patent Literature 1, Patent Literature 2, Non-Patent Literature 1, and Non-Patent Literature 2 disclose a perovskite solar cell in which a perovskite layer has a single orientation. These literatures suggest that such a perovskite layer is used to improve conversion efficiency of the perovskite solar cell.

### CITATION LIST

### Patent Literature

Patent Literature 1: Japanese Patent Application Publication No. 2016-025170
Patent Literature 2: Japanese Patent Application Publication No. 2016-092293

### Non-Patent Literature

Non-Patent Literature 1: Giulia Grancini and 10 other persons "Journal of Physical Chemistry Letters" (United States), 2014 May, p.3836 - 3842
Non-Patent Literature 2: Feng Wang and 2 other persons "Advanced Functional Materials" (Germany), 2015 February, Vol. 25, issue 7, p. 1120 - 1126

### DISCLOSURE OF INVENTION

It is required to improve the conversion efficiency of the perovskite solar cell more.

One aspect of the present disclosure provides a solar cell having higher conversion efficiency.

A solar cell according to one aspect of the present disclosure comprises a first electrode, a photoabsorber layer located on the first electrode and in which light is converted into electric charge, a second electrode located on the photoabsorber layer. The photoabsorber layer includes a first layer containing a first perovskite compound represented by the composition formula A¹M¹X¹₃ (where A¹ is a monovalent cation, M¹ is a divalent cation, and X¹ is a halogen anion) and a second layer located on the first layer and containing a second perovskite compound represented by the composition formula A²M²X²3 (where A² is a monovalent cation, M² is a divalent cation, and X² is a halogen anion). The first perovskite compound and the second perovskite compound have different compositions from each other.

In addition, these comprehensive or specific aspects can be achieved by a system, a method, an integrated circuit, a computer program, or a record medium, or can be achieved by any combination of the system, the method, the integrated circuit, the computer program, and the record medium.

In one aspect of the present disclosure, a solar cell having higher conversion efficiency is provided.

### BRIEF DESCRIPTION OF THE DRAWINGS

FIG. 1 is a cross-sectional view showing one example of a solar cell 100 according to the first embodiment schematically.
FIG. 2A is a schematic cross-sectional view for explaining an outline of a formation method of a photoabsorber layer 3.
FIG. 2B is a schematic cross-sectional view for explaining an outline of a formation method of a photoabsorber layer 3.
FIG. 2C is a schematic cross-sectional view of a photoabsorber layer 30 formed by a typical method.
FIG. 3A is a schematic view showing one example of the formation method of the photoabsorber layer 3.
FIG. 3B is a schematic view showing one example of the formation method of the photoabsorber layer 3.
FIG. 3C is a schematic view showing one example of the formation method of the photoabsorber layer 3.
FIG. 3D is a schematic view showing one example of the formation method of the photoabsorber layer 3.
FIG. 4 is a cross-sectional view showing one example of a solar cell 101 according to the second embodiment schematically.
FIG. 5 is a cross-sectional view showing one example of a solar cell 102 according to the third embodiment schematically.
FIG. 6A is a drawing showing an XRD measurement result of a first layer 11 of the photoabsorber layer 3 in the inventive example 1.
FIG. 6B is a drawing showing an XRD measurement result of a second layer 12 of the photoabsorber layer 3 in the inventive example 1.
FIG. 7A is a drawing showing an XRD measurement result of the first layer 11 of the photoabsorber layer 3 in the inventive example 2.
FIG. 7B is a drawing showing an XRD measurement result of the second layer 12 of the photoabsorber layer 3 in the inventive example 2.
FIG. 8A is a drawing showing an XRD measurement result of the first layer 11 of the photoabsorber layer 3 in the inventive example 3.
FIG. 8B is a drawing showing an XRD measurement result of the second layer 12 of the photoabsorber layer 3 in the inventive example 3.
FIG. 9A is a drawing showing an XRD measurement result of the first layer 11 of the photoabsorber layer 3 in the inventive example 4.
FIG. 9B is a drawing showing an XRD measurement result of the second layer 12 of the photoabsorber layer 3 in the inventive example 4.
FIG. 10A is a drawing showing an XRD measurement result of the first layer 11 of the photoabsorber layer 3 in the inventive example 5.
FIG. 10B is a drawing showing an XRD measurement result of the second layer 12 of the photoabsorber layer 3 in the inventive example 5.
FIG. 11 is a drawing showing an XRD measurement result of the photoabsorber layer in the comparative example 1.
FIG. 12 is a drawing showing external quantum efficiency of the solar cells of the inventive example 1 and the inventive example 2.

### DETAILED DESCRIPTION OF THE EMBODIMENT

### (Findings which established the foundation of the present disclosure)

In order to improve conversion efficiency of a solar cell, for example, it is proposed to raise short-circuit current density Jsc. Here, the conversion efficiency is calculated by dividing Jsc·Voc·FF by intensity of incident light, where Jsc is the short-circuit current density (A/Cm²), Voc is an open voltage (V), and FF is a fill factor (%). The short-circuit current density Jsc is a value calculated by dividing a short-circuit current by a light-receiving area. The short-circuit current is an electric current which flows when a voltage of the solar cell is 0 volts.

In the consideration by the present inventors, in the typical perovskite solar cell disclosed in the above literatures, it is difficult to take out carriers generated by photoexcitation as an electric current at high efficiency. Therefore, the loss of the electric current may be generated. For this reason, it is difficult to raise the short-circuit current density Jsc more. The reason therefor is that recombination of holes and electrons is generated in the solar cell before electrons and holes, both of which are carriers, are taken out to the outside, the present inventors believe.

The present inventors considered a structure and a formation method of a photoabsorber layer capable of raising the conversion efficiency of the solar cell. As a result, the present inventors found that the short-circuit current density of the solar cell is raised by using a photoabsorber layer having a structure in which a plurality of perovskite layers have been stacked to improve the conversion efficiency of the solar cell more. Hereinafter, the present invention will be described in more detail.

The perovskite layers are formed typically by an application method such as a spin-coating method. In the application method, the perovskite layer is formed, for example, by applying an application liquid which is a solution containing constituent elements of the perovskite compound and a solvent to a substrate, and then, heating for drying. However, it is difficult to form elements in which a plurality of the perovskite layers have been stacked. When an application liquid for forming an upper perovskite layer is applied to a lower perovskite layer, the perovskite compound contained in the lower perovskite layer may be dissolved in the application liquid.

On the other hand, the present inventors found that a photoabsorber layer having a stacking structure is formed by using the lower perovskite layer as a seed layer and precipitating the upper perovskite layer on the lower perovskite layer.

In the above method, it is possible to form the photoabsorber layer having a structure in which two perovskite layer having different compositions from each other have been stacked. In the photoabsorber layer, using a difference of the energy levels of a valence band and a conduction band of the two perovskite layers, the carrier recombination generated in the solar cell is prevented. Therefore, using such a photoabsorber layer, the conversion efficiency of the solar cell is raised more. The detail thereof will be described later.

In addition, in the method found by the present inventors, compared to the typical method, it is possible to control the orientation of the crystal of the perovskite compound in the perovskite layer easier. Furthermore, a perovskite layer in which the orientation of the crystal has been controlled can be formed so as to have a desired thickness. If the orientation of the crystal in the perovskite layer is aligned, the carriers migrate easily in the perovskite layer. This raises the short-circuit current density of the solar cell.

The summary of the embodiment of the present disclosure will be listed below.
[Item 1]
   A solar cell comprising:
   a first electrode;
   a second electrode opposite to the first electrode;
   a photoabsorber layer located between the first electrode and the second electrode and including a first layer and a second layer,
   wherein
   the first layer contains a first compound which has a perovskite structure represented by the composition formula A¹M¹X¹₃, where A¹ is a monovalent cation, M¹ is a divalent cation, and X¹ is a halogen anion;
   the second layer contains a second compound which has a perovskite structure represented by the composition formula A²M²X²₃, where A² is a monovalent cation, M² is a divalent cation, and X² is a halogen anion, and has a different composition from the first compound; and
   at least one of the first compound in the first layer and the second compound in the second layer has a single orientation.
[Item 2]
   The solar cell according to Item 1, wherein
   in the first layer, the first compound has a single orientation; and
   in the second layer, the second compound has a single orientation.
[Item 3]
   The solar cell according to Item 1 or 2, wherein
   the orientation of the first compound and the orientation of the second compound are aligned with each other.
[Item 4]
   The solar cell according to any one of Items 1 to 3, wherein
   in an X-ray diffraction pattern of the first layer using an CuKa ray, a first peak is present within a range of a diffraction angle of not less than 18° and not more than 23°;
   a diffraction intensity of the first peak is ten or more times as much as a maximum value of an diffraction intensity within a range of a diffraction angle of not less than 13° and not more than 16°;
   in an X-ray diffraction pattern of the second layer using an CuKa ray, a second peak is present within a range of a diffraction angle of not less than 18° and not more than 23°;
   a diffraction intensity of the second peak is ten or more times as much as a maximum value of a diffraction intensity within a range of a diffraction angle of not less than 13° and not more than 16°.
[Item 5]
   The solar cell according to any one of Items 1 to 3, wherein
   in an X-ray diffraction pattern of the first layer using an CuKa ray, a first peak is present within a range of a diffraction angle of not less than 13°and not more than 16°;
   a diffraction intensity of the first peak is ten or more times as much as a maximum value of an diffraction intensity within a range of a diffraction angle of not less than 18° and not more than 23°;
   in an X-ray diffraction pattern of the second layer using an CuKa ray, a second peak is present within a range of a diffraction angle of not less than 13° and not more than 16°;
   a diffraction intensity of the second peak is ten or more times as much as a maximum value of an diffraction intensity within a range of a diffraction angle of not less than 18° and not more than 23°.
[Item 6]
   The solar cell according to any one of Items 1 to 5, further comprising:
   a first carrier transport layer between the first electrode and the first layer.
[Item 7]
   The solar cell according to Item 6, wherein
   the first electrode is a negative electrode;
   the second electrode is a positive electrode; and
   the first carrier transport layer is an electron transport layer.
[Item 8]
   The solar cell according to Item 6 or 7, further comprising:
   a second carrier transport layer between the second electrode and the second layer.
[Item 9]
   The solar cell according to Item 8, wherein
   the first electrode is a negative electrode;
   the second electrode is a positive electrode; and
   the second carrier transport layer is a hole transport layer.
[Item 10]
   The solar cell according to any one of Items 1 to 9, wherein
   a thickness of the first layer is one-fourth or less times as much as a thickness of the second layer.
[Item 11]
   The solar cell according to any one of Items 1 to 10, wherein
   in the first compound, A¹ is CH₃NH₃⁺ and B¹ is Pb²⁺; and
   in the second compound, A² is NH₂CHNH₂⁺ and B² is Pb²⁺.
[Item 12]
   A photoabsorber layer comprising:
   a first layer containing a first compound which has a perovskite structure represented by the composition formula A¹M¹X¹₃, where A¹ is a monovalent cation, M¹ is a divalent cation, and X¹ is a halogen anion; and
   a second layer containing a second compound which has a perovskite structure represented by the composition formula A²M²X²₃, where A² is a monovalent cation, M² is a divalent cation, and X² is a halogen anion, and has a different composition from the first compound,
   wherein
   at least one of the first compound in the first layer and the second compound in the second layer has a single orientation.
[Item 13]
   The photoabsorber layer according to Item 12, wherein
   in the first layer, the first compound has a single orientation; and
   in the second layer, the second compound has a single orientation.
[Item 14]
   The photoabsorber layer according to Item 12 or 13, wherein
   the orientation of the first compound and the orientation of the second compound are aligned with each other.
[Item 15]
   A formation method of a photoabsorber layer, the method comprising:
   (A) disposing a first solution containing a monovalent cation A¹, a divalent cation M¹, and a halogen anion X¹ on a substrate, and then, drying the first solution, to form a first layer containing a first compound which has a perovskite structure represented by the composition formula A¹M¹X¹₃ and has a single orientation; and
   (B) disposing a second solution containing a monovalent cation A², a divalent cation M², and a halogen anion X² on the first layer, and then, drying the second solution, to form, on the first layer, a second layer containing a second compound which has a perovskite structure represented by the composition formula A²M²X²3 , has a single orientation, and is different from the first compound.
[Item 16]
   The formation method of the photoabsorber layer according to Item 15, wherein the second solution contains a lactone solvent.
[Item 17]
   The formation method of the photoabsorber layer according to Item 15 or 16, wherein
   In the step of (B), the substrate is heated to a temperature at which the second solution is in a saturated or oversaturated state, and then, the heated substrate is immersed in the second solution.

In addition, the summary of the embodiment of the present disclosure will be listed below.

A solar cell according to the embodiment of the present disclosure comprises:
a first electrode;
a photoabsorber layer which is located on the first electrode and is capable of converting light into electric charge; and
a second electrode disposed on the photoabsorber layer,
wherein
the photoabsorber layer includes a first layer containing a first perovskite compound represented by the composition formula A¹M¹X¹₃ (where A¹ is a monovalent cation, M¹ is a divalent cation, and X¹ is a halogen anion) and a second layer containing a second perovskite compound represented by the composition formula A²M²X²3 (where A² is a monovalent cation, M² is a divalent cation, and X² is a halogen anion); and
the first perovskite compound and the second perovskite compound have different composition from each other.

The orientation of the crystal in the first layer may be aligned, and the orientation of the crystal in the second layer may be aligned.

The orientations of the first and second compounds may be aligned with each other.
in an X-ray diffraction pattern of the first layer using an CuKa ray, in a case where a first range is defined as a range of angle 2θ of not less than 13 degrees and not more than 16 degrees and where a second range is defined as a range of angle 2θ of not less than 18 degrees and not more than 23 degrees, the first layer may have a first peak within the second range, the intensity of the first peak is, for example, ten or more times as much as a maximum value of the intensity within the first range of the first layer, the second layer may have a second peak within the second range, and the intensity of the second peak is, for example, ten or more times as much as a maximum value of the intensity within the first range of the second layer.
in an X-ray diffraction pattern of the first layer using an CuKa ray, in a case where a first range is defined as a range of angle 2θ of not less than 13 degrees and not more than 16 degrees and where a second range is defined as a range of angle 2θ of not less than 18 degrees and not more than 23 degrees, the first layer may have a first peak within the first range, the intensity of the first peak is, for example, ten or more times as much as a maximum value of the intensity within the second range of the first layer, the second layer may have a second peak within the first range, and the intensity of the second peak is, for example, ten or more times as much as a maximum value of the intensity within the second range of the second layer.

The solar cell may further comprise a first carrier transport layer located between the first electrode and the first layer.

The first electrode may be a negative electrode, the second electrode may be a positive electrode, and the first carrier transport layer may be an electron transport layer.

The solar cell may further comprise a second carrier transport layer located between the second electrode and the second layer.

The first electrode may be a negative electrode, the second electrode may be a positive electrode, and the second carrier transport layer may be a hole transport layer.

A thickness of the first layer may be one-fourth or less times as much as a thickness of the second layer.

In the composition formula of the first perovskite compound, A¹ may be CH₃NH₃⁺ and B¹ may be Pb²⁺, and, in the composition formula of the second perovskite compound, A² may be NH₂CHNH₂⁺ and B² may be Pb²⁺.

A photoabsorber layer according to the embodiment of the present disclosure comprises:
the first layer containing a first perovskite compound represented by the composition formula A¹M¹X¹₃ (where A¹ is a monovalent cation, M¹ is a divalent cation, and X¹ is a halogen anion); and
the second layer contains a second perovskite compound represented by the composition formula A²M²X²3 (where A² is a monovalent cation, M² is a divalent cation, and X² is a halogen anion),
wherein
the first perovskite compound and the second perovskite compound have different composition from each other.

The orientation of the crystal in the first layer may be aligned, and the orientation of the crystal in the second layer may be aligned.

The orientations of the first and second layers may be aligned.

A formation method of a photoabsorber layer comprises:
(A) applying a first solution containing constituent elements of a first perovskite compound represented by composition formula A¹M¹X¹₃ (where A¹ is a monovalent cation, M¹ is a divalent cation, and X¹ is a halogen anion) to a substrate, and then, drying the first solution, to form a first layer containing the first perovskite compound; and
(B) leaving the substrate at rest in a state where a second solution containing constituent elements of a second perovskite compound represented by composition formula A²M²X²3 (where A² is a monovalent cation, M² is a divalent cation, and X² is a halogen anion) is in contact with an upper surface of the first layer, to precipitate the second layer containing the second perovskite compound on the first layer,
wherein
the perovskite compound and the second perovskite compound have the same as or different composition from the each other.

The second solution may contain a lactone solvent.

In the step of (B), the substrate may be heated to a temperature at which the second solution 52 is in a saturated or oversaturated state, and then, the heated substrate is immersed in the second solution to bring the second solution into contact with the upper surface of the first layer.

The second layer may have an orientation which has reflected the orientation of the crystal in the first layer.

### (First embodiment)

A solar cell of the first embodiment of the present disclosure will be described with reference to the drawings.

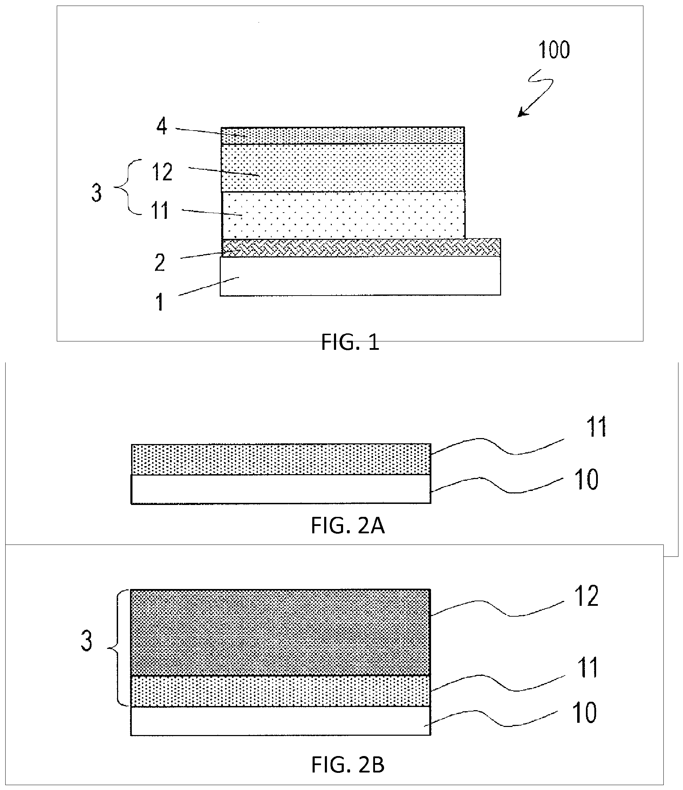

FIG. 1 is a cross-sectional view showing one example of the solar cell of the present embodiment schematically.

The solar cell 100 comprises a first electrode 2, a photoabsorber layer 3, and a second electrode 4. The photoabsorber layer 3 is located on the first electrode 2 and converts light into electric charge. The second electrode 4 is located on the photoabsorber layer 3. The photoabsorber layer 3 includes a first layer 11 and a second layer 12 which is located on the first layer 11. The first layer 11 contains a first perovskite compound represented by the composition formula A¹M¹X¹₃. In the formula, A¹ is a monovalent cation, M¹ is a divalent cation, and X¹ is a halogen anion. The second layer 12 contains a second perovskite compound represented by the composition formula A²M²X²₃. In the formula, A² is a monovalent cation, M² is a divalent cation, and X² is a halogen anion. Each of A¹, A², M¹, M², X¹ and X² may be composed of one kind of element, or may include two or more kinds of elements. The first perovskite compound and the second perovskite compound have different compositions from each other.

Hereinafter, the fundamental function effect of the solar cell 100 will be described. When the solar cell 100 is irradiated with light, the light is absorbed into the photoabsorber layer 3 to generate holes and excited electrons. The excited electrons migrate to the first electrode 2, which is a negative electrode. On the other hand, the holes generated in the photoabsorber layer 3 migrate to the second electrode 4, which is a positive electrode. In this way, electric current is taken out from the negative electrode and the positive electrode of the solar cell 100.

In the present embodiment, the first electrode 2 serves as the negative electrode and the second electrode 4 serves as the positive electrode. However, the first electrode 2 may serve as the positive electrode and the second electrode 4 may serve as the negative electrode.

The solar cell 100 may comprise a substrate 1. In this case, the first electrode 2 may be located on the substrate 1.

"The compositions of the first perovskite compound and the second perovskite compound are different from each other" means that at least one of the monovalent cation, the divalent cation, and the halogen anion in the composition formula of the first perovskite compound is different from that of the second perovskite compound. In other words, elements are different from each other in at least one pair of A¹ and A², M¹ and M², and X¹ and X². Note that any one of A¹, A², M¹, M², X¹ and X² may include two or more kinds of elements in the first perovskite compound and the second perovskite compound. In this case, "the compositions of the first perovskite compound and the second perovskite compound are different from each other" means that element ratio included in the at least one pair of A¹ and A², M¹ and M², and X¹ and X² is different.

In addition, the solar cell 100 according to the present embodiment has a first layer 11 and a second layer 12 which is disposed on the first layer 11. The compositions of the first perovskite compound contained in the first layer 11 and the second perovskite compound contained in the second layer 12 are different from each other. This allows the short-circuit current density to be raised more than a typical solar cell comprising a photoabsorber layer having a single perovskite layer. The reason therefor will be described.

The compositions of the perovskite compounds contained in the first layer 11 and the second layer 12, both of which constitute the photoabsorber layer 3, are different from each other. Therefore, the valance bands and the conduction bands of the first layer 11 and the second layer 12 have different energy levels from each other. This generates an incline in the valance bands and the conduction bands in the photoabsorber layer 3 due to the difference of the energy levels of the first layer 11 and the second layer 12. This allows the carriers generated when the photoabsorber layer 3 is irradiated with light to migrate easily in a predetermined direction. For example, in a case where the energy levels of the valance band and the conduction band of the first perovskite compound are higher the energy levels of the valance band and the conduction band of the second perovskite compound, electrons migrate easily from the first perovskite compound toward the second perovskite compound. On the other hand, holes migrate easily from the second perovskite compound toward the first perovskite compound. As just described, the direction in which electrons migrate easily is opposite to the direction in which holes migrate easily. For this reason, since the electrons and holes generated in the photoabsorber layer upon the irradiation with light migrate in the opposite direction to each other, the electrons and holes are easily separated. Therefore, the recombination of the carriers is prevented in the solar cell 100. This allows the short-circuit current density in the solar cell to be increased to raise the conversion efficiency.

The solar cell 100 according to the present embodiment may be fabricated, for example, by the following method. First, the first electrode 2 is formed on a surface of the substrate 1 by a sputtering method. Next, the photoabsorber layer 3 is formed on the first electrode 2 by an application method. Subsequently, the second electrode 4 is formed on the photoabsorber layer 3 by a sputtering method. In this way, the solar cell 100 is provided.

### (Function effect and Constituent element of Solar cell 100)

Hereinafter, the constituent elements of the solar cell 100 will be described.

### (Substrate 1)

The substrate 1 is an optional constitution element. The substrate 1 holds the layers of the solar cell 100. The substrate 1 may be formed of a transparent material. An example of the transparent material is glass or plastic. An example of the plastic substrate is a plastic film. When the first electrode 2 has sufficient strength, the layers can be hold by the first electrode 2. Therefore, the substrate 1 does not have to be provided.

### (First electrode 2)

The first electrode 2 has an electric conductivity. The first electrode 2 does not form an ohmic contact with the first perovskite compound. Furthermore, the first electrode 2 has a hole block property that the holes migrating from the first perovskite compound are blocked. The hole block property is to allow only electrons generated in the photoabsorber layer 3 and present at an interface between the first perovskite compound and the first electrode 2 to travel through the first electrode 2 and to prevent holes generated in the photoabsorber layer 3 and present at an interface between the first perovskite compound and the first electrode 2 from traveling through the first electrode 2. The material having the hole block property is a material having a higher Fermi energy than the energy level at the upper end of the valence band of the photoabsorber layer 3. An example of the material is aluminum.

The first electrode 2 is light-transmissive. The first electrode 2 has a characteristic that visible light and near-infrared light pass through the first electrode 2, for example. The first electrode 2 may be formed of a transparent and electrically-conductive metal oxide. An example of the transparent and electrically-conductive metal oxide is, for example, an indium - tin composite oxide, a tin oxide doped with antimony, a tin oxide doped with fluorine, a zinc oxide doped with boron, aluminum, gallium, or indium, or a composite thereof.

The first electrode 2 may be formed of a material which is not transparent. In this case, a material which is not transparent may be disposed at a predetermined pattern in such a manner that light passes through partially. An example of the predetermined pattern is a line, a wave, a grid, a pattern having a shape in which a lot of fine through holes are arranged regularly or irregularly, or a pattern in which a region having the material which is not transparent and a region not having the material which is not transparent are inverted in these patterns. If the first electrode 2 has any one of these patterns, light can pass through the region not having the material of the electrode. An example of the material which is not transparent is, for example, platinum, gold, silver, copper, aluminum, rhodium, indium, titanium, iron, nickel, tin, zinc, or an alloy containing any of these. An electrically-conductive carbon material may be used as the material of the electrode.

Light-transmissivity of the first electrode 2 is, for example, not less than 50%. Light-transmissivity of the first electrode 2 may be not less than 80%. A wavelength of the light which passes through the first electrode 2 is dependent on an absorption wavelength of the photoabsorber layer 3. The thickness of the first electrode 2 falls within a range of, for example, not less than 1 nanometer and not more than 1,000 nanometers.

### (Photoabsorber Layer 3)

The photoabsorber layer 3 has a stacking structure including the first layer 11 and the second layer 12. The photoabsorber layer 3 may include another layer besides the first layer 11 and the second layer 12.

The first layer 11 mainly contains the first perovskite compound represented by the composition formula A¹M¹X¹₃. The second layer 12 mainly contains the second perovskite compound represented by the composition formula A²M²X²₃. A¹ and A² are monovalent cations. An example of A¹ and A² is a monovalent cation such as an alkali metal cation or an organic cation. More specifically, an example of A¹ and A² is a methylammonium cation (CH₃NH₃⁺), a formamidinium cation (NH₂CHNH₂⁺), or a cesium cation (Cs⁺). M¹ and M² are divalent cations. An example of M¹ and M² is a divalent cation of a transition metal or a group 13 - 15 element. More specifically, an example of M¹ and M² is Pb²⁺, Ge²⁺, or Sn²⁺. X¹ and X² are monovalent anions such as a halogen anion. Each of the sites of A¹, A², M¹, M², X¹, and X² may be occupied with a plurality of kinds of ions. An example of the compound having the perovskite structure is CH₃NH₃PbI₃, CH₃CH₂NH₃PbI₃, NH₂CHNH₂PbI₃, CH₃NH₃PbBr₃, CH₃NH₃PbCl₃, CsPbI₃, or CsPbBr₃.

Each of the first layer 11 and the second layer 12 may have a single orientation. In the present disclosure, "having a single orientation" means a state where the orientation of the crystal in a layer is substantially aligned, namely, means a state where almost all of the parts of the crystal in the layer are oriented in one direction. For example, in a case where a crystal is grown in such a manner that a (100) plane in the crystal of the first perovskite compound in the first layer 11 is parallel to an interface between the first layer 11 and the first electrode 2, the first layer 11 "has a single orientation in a (100) direction", or, simply, "has a (100) orientation". When one of the first layer 11 or the second layer 12 has a single orientation, or when both of the first layer 11 and the second layer 12 have single orientations, the carriers migrate easily in the layer in which the orientation is aligned. This allows the short-circuit current density of the solar cell to be raised more effectively.

Each of the first perovskite compound contained in the first layer 11 and the second perovskite compound contained in the second layer 12 may be monocrystalline or polycrystalline. If the first perovskite compound or the second perovskite compound is polycrystalline, "the first layer 11 or the second layer 12 has a single orientation" means that the orientations of a plurality of the crystalline regions of the first perovskite compound or the second perovskite compound are aligned substantially with each other. Both of the first perovskite compound and the second perovskite compound may be monocrystalline or polycrystalline. Alternatively, the first perovskite compound is monocrystalline and the second first perovskite compound is polycrystalline, and conversely.

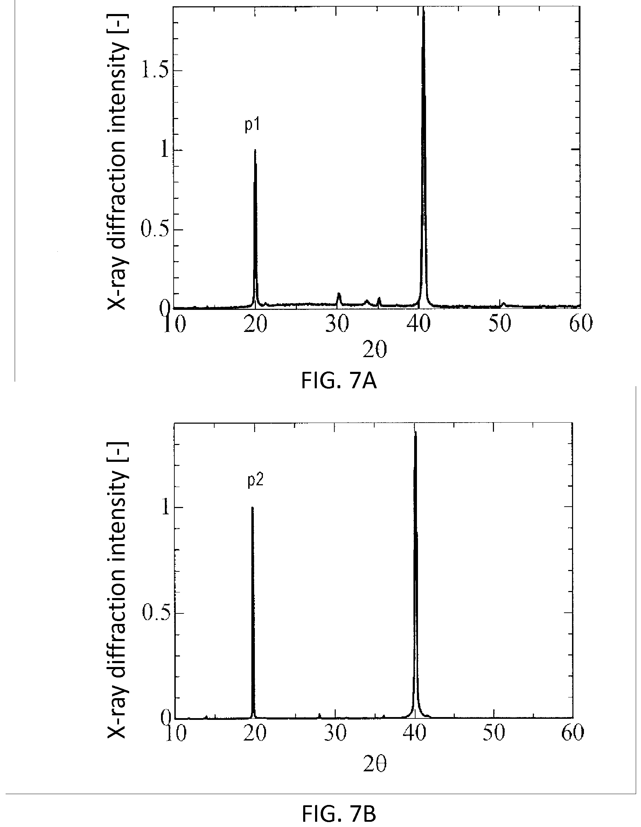

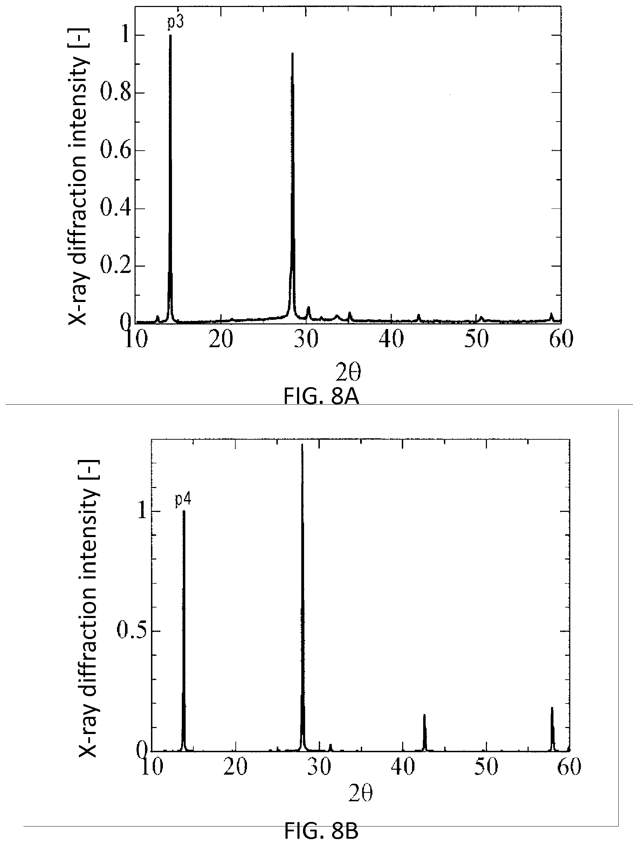

The orientation of the perovskite layer can be evaluated with an X-ray diffraction (XRD) measurement. If the perovskite layer has a single orientation, intense peaks appear only at a specific angle and the constant multiple angles thereof in the XRD measurement result. For example, If the perovskite compound is CH₃NH₃PbI₃ and has a single orientation in a (100) direction, peaks appear only near angles 2θ of 14°, 28°, and 42° (See FIG. 8A and FIG. 8B, which will be described later). Alternatively, If the perovskite compound is CH₃NH₃PbI₃ and has a single orientation in a (110) direction, peaks appear only near angles 2θ of 20° and 40° (See FIG. 7A and FIG. 7B, which will be described later). Here, the angle 2θ means a diffraction angle.

The first layer 11 and the second layer 12 may have the same orientation as each other. In other words, the orientation of the crystal of the first perovskite compound contained in the first layer 11 and the orientation of the crystal of the second perovskite compound contained in the second layer 12 may be aligned with each other. The following two requirements are satisfied, if the orientation of the crystal of the first perovskite compound and the orientation of the crystal of the second perovskite compound are aligned with each other. The first requirement is that each of the first perovskite compound and the second perovskite compound has single orientation. The second requirement is that plane orientations of the first perovskite compound and the second perovskite compound on surfaces parallel to interfaces of the first layer 11 and the second layer 12 are the same as each other. For example, it is presumed that both of the crystals of the first perovskite compound and the second perovskite compound are cubical crystals. In this case, when the crystal is grown in such a manner that (100) surfaces of the both of the crystals are parallel to the interface of the first layer 11 and the second layer 12, in other words, when both the first layer 11 and the second layer 12 have single orientations in a (100) direction, the orientations of the two layers are aligned with each other. If the orientations are aligned between the first layer 11 and the second layer 12, migration of the carriers is poorly prevented at the interface of the first layer 11 and the second layer 12. Therefore, the short-circuit current density of the solar cell is allowed to be raised more.

Whether or not the orientations of the crystals of the perovskite compounds contained in the layers are aligned with each other is determined on the basis of whether or not only peaks attributed to the same orientation appear in the XRD measurement results of the first layer 11 and the second layer 12. In addition, if the orientations of the crystal of the first perovskite compound and the crystal of the second perovskite compound are aligned with each other, and if the lattice constants of the crystals are close to each other, intense peaks appear at positions close to each other in the XRD measurement results of the first layer 11 and the second layer 12. For example, if the difference of the lattice constants of the first perovskite compound and the second perovskite compound is not more than 10%, the difference of the angles 2θ at which intense peaks derived from the same diffraction plane appear may be not more than 5%.

As one example, hereinafter, a first range is define by a range within which 13° ≤ 2θ ≤ 16° is satisfied and a second range is define by a range within which 18° ≤ 2θ ≤ 23° is satisfied. In a case where a first peak p1 is present within the second range in the X-ray diffraction result using the CuKa ray in the first layer 11, where intensity of the first peak p1 is ten or more times as much as the maximum value of the intensity within the first range, where a second peak p2 is present within the second range in the X-ray diffraction result using the CuKa ray in the second layer 12, and where intensity of the second peak p2 is ten or more times as much as the maximum value of the intensity within the first range, it is believed that the orientations of the first layer 11 and the second layer 12 are aligned with each other. In other words, it is believed that the first layer 11 and the second layer 12 have the same orientations (See FIG. 7A and FIG. 7B, which will be described later). In addition, in this case, it is believed that each of the first layer 11 and the second layer 12 has a (110) orientation.

In addition, as another example, hereinafter, a first range is define by a range within which 13° ≤ 2θ ≤ 16° is satisfied and a second range is define by a range within which 18° ≤ 2θ ≤ 23° is satisfied. In a case where a third peak p3 is present within the first range in the X-ray diffraction result using the CuKa ray in the first layer 11, where intensity of the third peak p3 is ten or more times as much as the maximum value of the intensity within the second range, where a fourth peak p4 is present within the first range in the X-ray diffraction result using the CuKa ray in the second layer 12, and where intensity of the fourth peak p4 is ten or more times as much as the maximum value of the intensity within the second range, it is believed that the orientations of the first layer 11 and the second layer 12 are aligned with each other (See FIG. 8A and FIG. 8B, which will be described later). In addition, in this case, it is believed that each of the first layer 11 and the second layer 12 has a (100) orientation.

### (Formation method of Photoabsorber layer 3)

Next, the formation method of the photoabsorber layer 3 according to the present embodiment will be described with reference to the drawings.

FIG. 2A and FIG. 2B are schematic cross-sectional view for explaining an outline of the formation method of the photoabsorber layer 3.

First, a ground substrate 10 on which a first electrode (not shown) has been formed on the surface thereof is prepared.

Then, as shown in FIG. 2A, the first layer 11 is formed on the ground substrate 10. The first layer 11 may be formed by a known method. The first layer 11 may be formed by an application method such as a spin-coating method. At this time, as the first layer 11, a perovskite layer having a single orientation may be formed. Such a perovskite layer may be formed by controlling process condition. The process condition to be controlled is, for example, a material contained in an application liquid or a temperature to which the application liquid is heated. For example, an example of the application method is a method in which a dimethylsulfoxide solution containing methylammonium iodide (i.e., CH₃NH₃I) and PbI₂ ,each of which has a concentration of 1 mol/L, is applied to a substrate by a spin-coating method at 3,000 rpm. In this method, a droplet of chlorobenzene is not put down during the spin coat of the dimethylsulfoxide solution. In this method, a perovskite layer of CH₃NH₃PbI₃ having a (110) orientation is provided. In addition, an example of the application method is a method in which a dimethylsulfoxide solution containing CH₃NH₃I at a concentration of 3 mol/Lmol/L and PbI₂ at a concentration of 1 mol/L is applied to a substrate by a spin-coating method at 3,000 rpm. In this method, a perovskite layer of CH₃NH₃PbI₃ having a (100) orientation is provided.

Subsequently, as shown in FIG. 2B, the second layer 12 is formed on the first layer 11. The second layer 12 may be formed, for example, by precipitating the second perovskite compound on the first layer 11, using the first layer 11 as a seed layer. If the first layer 11 has a single orientation, a crystal of the second perovskite compound may be grown with reflection of the orientation of the first layer 11. In this way, the second layer 12 having the same orientation as that of the first layer 11 is formed. The thickness of the second layer 12 is not limited. The second layer 12 may be thicker than the first layer 11, which is, for example, the seed layer.

The photoabsorber layer containing the perovskite compound represented by AMX₃ was formed typically by an application method. For this reason, as described above, it was difficult to form a photoabsorber layer having a structure in which perovskite layers are stacked. In addition, it was difficult to increase the thickness of the photoabsorber layer. On the other hand, in the above method, it is possible to form the photoabsorber layer 3 having a stacking structure. In addition, in the above method, the photoabsorber layer 3 having a desired thickness is easily formed. For example, the formation condition such as a period during which the perovskite compound is precipitated is controlled to increase the thickness of the second layer 12. Therefore, it is possible to form the photoabsorber layer 3 which is thicker than that fabricated by a typical method.

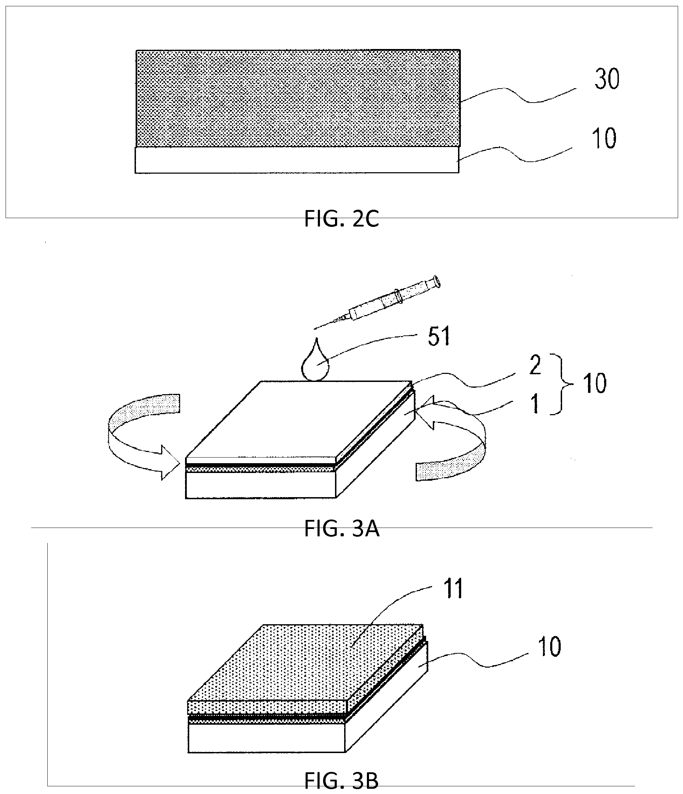

Furthrermore, in the above method, since it is possible to form the photoabsorber layer 3 in which the orientations of the crystals are aligned with each other, the short-circuit current density of the solar cell is improved more effectively. FIG. 2C is a cross-sectional which exemplifies the photoabsorber layer 30 formed by a typical method. As shown in FIG. 2C, if the relatively thick photoabsorber layer 30 was formed by an application method, it was difficult to align the orientations of the crystals of the perovskite compounds in the photoabsorber layer 30 with each other. On the other hand, in the above method, the orientation of the crystal of the first perovskite compound contained in the first layer 11 which serves as the seed layer is controlled to control the orientation of the crystal of the second perovskite compound contained in the second layer 12. In addition, in the above method, even if the first layer 11 is formed thinly to align the orientation of the crystal of the first perovskite compound, the second layer 12 is formed thickly to ensure the thickness of the photoabsorber layer 3. Therefore, it is possible to form the photoabsorber layer 3 which has a desired thickness and in which the orientation of the crystal of the compound is aligned in the layer.

The thickness of the first layer 11 and the second layer 12 is not limited. The first layer 11 has a thickness of, for example, not less than 10 nanometers and not more than 100 nanometers. If the first layer 11 has a thickness of not less than 10 nanometers, the possibility to serve as the seed layer is raised. On the other hand, if the first layer 11 has a thickness of not more than 100 nanometers, the possibility that the first layer 11 having a single orientation is formed is raised. On the other hand, the second layer 12 can have a single orientation, if it is relatively thick. The thickness of the second layer 12 may be, for example, not less than 0.1 micrometer and not more than 100 micrometers. The second layer 12 may be thicker than the first layer 11. The thickness of the second layer 12 may be, for example, four or more times as much as the thickness of the first layer 11, or may be ten or more times as much as the thickness of the first layer 11. The thickness of the photoabsorber layer 3, namely, the sum of the thicknesses of the first layer 11 and the second layer 12 may be, for example, not less than 0.1 micrometer and not more than 100 micrometers.

Next, the formation method of each of the layers in the photoabsorber layer 3 will be described specifically.

FIG. 3A- FIG. 3D are schematic views showing one example of the formation method of the photoabsorber layer 3 according to the present embodiment.

First, as shown in FIG. 3A, a first electrode 2 is formed on a substrate 1 to form the ground substrate 10. Note that a substrate in which a first carrier transport layer has been further formed on the first electrode 2 may be used as the ground substrate 10. An example of the carrier transport layer is a hole transport layer or an electron transport layer. The hole transport layer and the electron transport layer will be described later.

Next, a first solution 51 containing constituent elements of the first perovskite compound is prepared. The first solution 51, for example, contains M¹X¹₂ and A¹X¹, both of which are starting materials of the first perovskite compound A¹M¹X¹₃, and a solvent. The solvent may be a solvent capable of dissolving M¹X¹₂ and A¹X¹, both of which are starting materials. An example of the solvent is an organic solvent. An example of the organic solvent is an alcohol solvent, an amide solvent, a nitrile solvent, a hydrocarbon solvent, or a lactone solvent. Two or more kinds of these solvents are mixed to use. In addition, an additive agent may be mixed with the solvent. The additive agent is added to promote crystal growth due to generation of a core of the crystal of the first perovskite compound. An example of the additive agent is hydrogen iodide, amine, or surfactant.

Then, the first solution 51 is added to an upper surface of the first electrode 2. An example of the method for adding the first solution 51 is an application method or a printing method. An example of the application method is a spin-coating method or a dip-coating method.

Then, the ground substrate 10 which the first solution 51 has been added is heated at a first temperature. The first temperature may be a temperature at which the solvent of the first solution 51 is dried. For example, the first temperature is 100 degrees Celsius. In this way, as shown in FIG. 3B, the first layer 11 containing the first perovskite compound is formed.

Subsequently, a second solution 52 containing constituent elements of the second perovskite compound is prepared. The second solution 52 contains M²X²₂ and A²X², both of which are starting materials of the second perovskite compound A²M²X²₃, and a solvent. A solvent similar to that of the first solution 51 may be used as the solvent. As the solvent of the second solution 52, a lactone may be used. An example of the lactone is γ-butyrolactone.

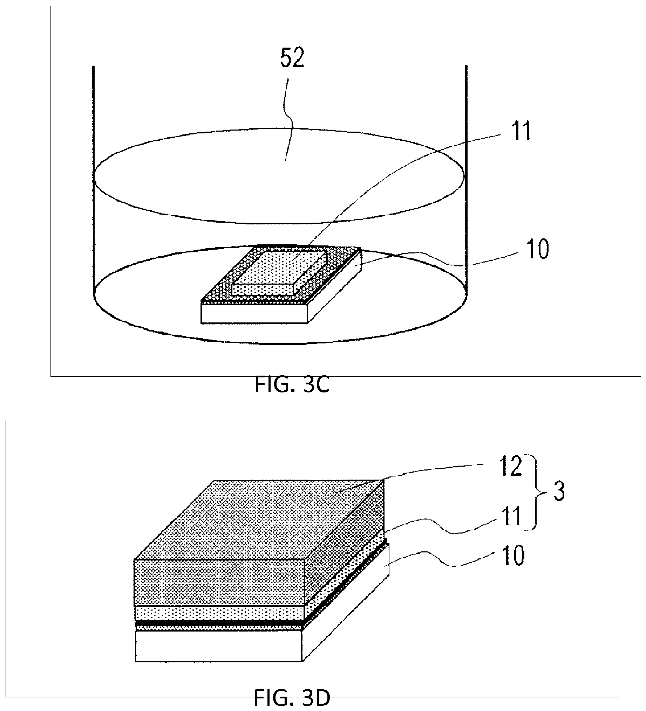

Next, as shown in FIG. 3C, the ground substrate 10 on which the first layer 11 has been formed is immersed in the second solution 52. For example, the second solution 52 containing PbX₂ and CH(NH₂)₂X (where X is a halogen element) is heated to a second temperature, and then, the ground substrate 10 heated to the same temperature is immersed. The second temperature may be configured to be a temperature at which the starting material of the first perovskite compound is in a saturated or oversaturated condition with regard to the solvent of the second solution 52. In this way, the first perovskite compound in the first layer 11 is prevented from being dissolved in the second solution 52. For example, if the second solution 52 contains a lactone solution, the second solution 52 is in the oversaturated condition at a temperature of room temperature - 150 degrees Celsius with regard to the starting material of the first perovskite compound having a predetermined amount. For this reason, the second temperature may be configured to be, for example, not more than 130 degrees Celsius. The second temperature is, for example, 100 degrees Celsius. Note that at least the ground substrate 10 may be heated to the second temperature. For example, if the second solution 52 is in the saturated or oversaturated condition with regard to the starting material of the first perovskite compound, the heating temperature of the second solution 52 may be lower than the heating temperature of the ground substrate 10. Alternatively, the second solution 52 does not have to be heated.

The ground substrate 10 is immersed in the second solution 52 to precipitate the second perovskite compound on the first layer 11. As a result, as shown in FIG. 3D, the second layer 12 is formed. The period during which the ground substrate 10 is left at rest in the second solution 52 is adjusted to control the thickness of the second layer 12. Note that the second perovskite compound may be precipitated, while the temperature of the second solution 52 is maintained at the second temperature, if the second solution 52 is in the oversaturated condition.

As described with reference to FIG. 2A and FIG. 2B, in a case where the orientation of the crystal of the first perovskite compound in the first layer 11 is aligned, the crystal of the second perovskite compound is grown with reflecting the orientation. As a result, the second layer 12 having the same orientation as that of the first layer 11 is formed. Then, the ground substrate 10 is taken out from the second solution 52. In this way, the photoabsorber layer 3 is formed.

In the above method, the second layer 12 is formed on the first layer 11, which is the seed layer. The compositions of the first perovskite compound 11 contained in the first layer 11 and the second perovskite compound contained in the second layer 12 may be the same as or different from each other. In a case where the compositions of the first perovskite compound and the second perovskite compound are the same as each other, and where both of the orientations are aligned with each other, the interface of the first layer 11 and the second layer 12 may be clearly undefined.

Note that the step of precipitating the second perovskite compound is not limited to the step shown in FIG. 3C. The second perovskite compound may be precipitated while the second perovskite compound is grown on the first layer 11 with holding the ground substrate 10 in a condition where the second solution 52 is in contact with the upper surface of the first layer 11. For example, the second solution 52 heated to the second temperature may be added onto the first layer 11, and then, be left at rest to grow the second perovskite compound. Subsequently, for example, the ground substrate 10 is rotated to remove the left second solution 52 from the ground substrate 10.

### (Second Electrode 4)

The second electrode 4 has electrical conductivity. In addition, the second electrode 4 is not in ohmic contact with the second perovskite compound. Furthermore, the second electrode 4 has an electron block property that the electrons migrating from the second perovskite compound are blocked. The electron block property is to allow only holes generated in the photoabsorber layer 3 and located at the interface between the second perovskite compound and the second electrode 4 to travel through the second electrode 4 and to prevent electrons generated in the photoabsorber layer 3 and located at the interface between the second perovskite compound and the second electrode 4 from traveling through the second electrode 4. The material having the electron block property is a material having a lower Fermi energy than the energy at the lower end of the conduction band of the photoabsorber layer 3. An example of the material is gold or a carbon material such as graphene.

At least one electrode on which light is incident, of the first electrode 2 and the second electrode 4, is light-transmissive. For example, if the second electrode 4 is light-transmissive, the first electrode 2 does not have to be light-transmissive.

### (Second embodiment)

The solar cell according to the second embodiment is different from the solar cell 100 shown in FIG. 1 in further comprising the electron transport layer.

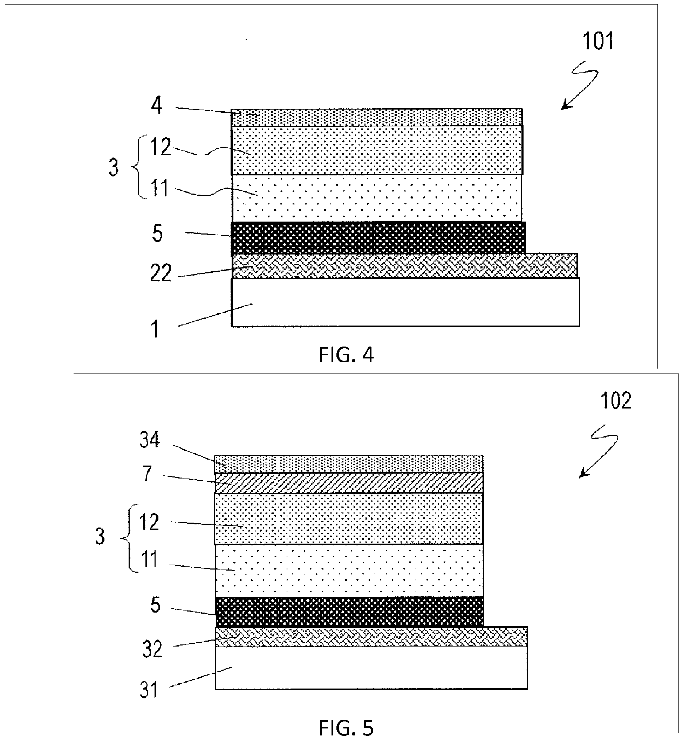

FIG. 4 is a schematic cross-sectional view of the solar cell 101 according to the present embodiment. In FIG. 4, with regard to the constituent elements having the same function and configuration as those of the solar cell 100, the signs common to those of the solar cell 100 are assigned and the description thereof will be omitted.

The solar cell 101 comprises the substrate 1, a first electrode 22, an electron transport layer 5 located on the first electrode 22, the photoabsorber layer 3 located on the electron transport layer 5, and the second electrode 4 located on the photoabsorber layer 3. The photoabsorber layer 3 comprises the first layer 11 containing the first perovskite compound and the second layer 12 which is located on the first layer 11 and contains the second perovskite compound. In this embodiment, the first electrode 22 serves as a negative electrode and the second electrode 4 serves as a positive electrode. The electron transport layer 5 is provided as a first carrier transport layer between the first electrode 22 and the first layer 11.

The fundamental function effect of the solar cell 101 according to the present embodiment will be described. When the solar cell 101 is irradiated with light, the light is absorbed into the photoabsorber layer 3 to generate holes and excited electrons. The excited electrons migrate through the electron transport layer 5 to the first electrode 22. On the other hand, the holes generated in the photoabsorber layer 3 migrate to the second electrode 4. In this way, electric current is taken out from the first electrode 22 and the second electrode 4, which serve as the negative electrode and the positive electrode of the solar cell 101, respectively.

In the present embodiment, the electron transport layer 5 is provided. For this reason, the first electrode 22 does not have to have the hole block property that the holes migrating from the first perovskite compound are blocked. Therefore, the range of the choice of the material of the first electrode 22 is expanded.

The solar cell 101 according to the present embodiment can be fabricated in the same way as that of the solar cell 100 according to the first embodiment. The electron transport layer 5 is formed on the first electrode 22, for example, by a sputtering method.

Hereinafter, elements of the solar cell 101 will be described in more detail.

### (First electrode 22)

The first electrode 22 has electric conductivity. The first electrode 22 may have the same configuration as the first electrode 2. Since the electron transport layer 5 is used in the present embodiment, the first electrode 22 does not have to have the hole block property that the holes migrating from the first perovskite compound are blocked. In other words, the material of the first electrode 22 may be a material capable of being in ohmic contact with the first perovskite compound.

### (Electron Transport Layer 5)

The electron transport layer 5 contains a semiconductor. The electron transport layer 5 may contain a semiconductor having a bandgap of not less than 3.0 eV. Visible light and infrared light travels through the electron transport layer 5 formed of the semiconductor having a bandgap of not less than 3.0 eV to reach the photoabsorber layer 3. An example of the semiconductor is an organic or inorganic n-type semiconductor.

An example of the organic n-type semiconductor is an imide compound, a quinone compound, fullerene, or a derivative thereof. An example of the inorganic n-type semiconductor is a metal oxide or a perovskite oxide. An example of the metal oxide is an oxide of Cd, Zn, In, Pb, Mo, W, Sb, Bi, Cu, Hg, Ti, Ag, Mn, Fe, V, Sn, Zr, Sr, Ga, Si, or Cr. As a more specific example, TiO₂ is exemplified. An example of the perovskite oxide is SrTiO₃ or CaTiO₃.

The electron transport layer 5 may be formed of a material having a bandgap of more than 6.0 eV. An example of the material having a bandgap of more than 6.0 eV is a halide of an alkali metal, a halide of an alkali-earth metal, an oxide of an alkali-earth metal, or silicon dioxide. An example of the halide of the alkali metal is lithium fluoride. An example of the halide of the alkali-earth metal is calcium fluoride. An example of the oxide of the alkali-earth metal is magnesium oxide. In this case, to ensure the electron transport property of the electron transport layer 5, the thickness of the electron transport layer 5 may be, for example, not more than 10 nanometers.

The electron transport layer 5 may be formed by stacking the same materials or by stacking different materials alternately.

Note that the configuration of the solar cell according to the present embodiment is not limited to the example shown in FIG. 4. The first electrode 22 may serve as the positive electrode and the second electrode 4 may serve as the negative electrode. In this case, the electron transport layer 5 is provided between the second electrode 4 and the second layer 12.

### (Third embodiment)

The solar cell according to the third embodiment is different from the solar cell 101 shown in FIG. 4 in further comprising the hole transport layer 6.

FIG. 5 is a schematic cross-sectional view of the solar cell 102 according to the present embodiment. In FIG. 5, with regard to the constituent elements having the same function and the configuration as those of the solar cell 101, the signs common to those of the solar cell 101 are assigned and the description thereof will be omitted.

The solar cell 102 comprises a substrate 31, a first electrode 32, the electron transport layer 5 located on the first electrode 32, the photoabsorber layer 3 located on the electron transport layer 5, the hole transport layer 6 located on the photoabsorber layer 3, and a second electrode 34 located on the hole transport layer 6. The photoabsorber layer 3 has the first layer 11 containing the first perovskite compound and the second layer 12 which is located on the first layer 11 and contains the second perovskite compound. In this embodiment, the first electrode 32 serves as a negative electrode and the second electrode 34 serves as a positive electrode. The electron transport layer 5 is provided as the first carrier transport layer between the first electrode 32 and the first layer 11. In addition, the hole transport layer 6 is provided as the second carrier transport layer between the second electrode 34 and the second layer 12.

The fundamental function effect of the solar cell 102 will be described.

When the solar cell 102 is irradiated with light, the light is absorbed into the photoabsorber layer 3 to generate holes and excited electrons. The excited electrons migrate to the electron transport layer 5. On the other hand, the holes generated in the photoabsorber layer 3 migrate to the hole transport layer 6. The electron transport layer 5 is connected to the first electrode 32 and the hole transport layer 6 is connected to the second electrode 34. In this way, electric current is taken out from the first electrode 32 and the second electrode 34, which serve as the negative electrode and the positive electrode of the solar cell 102, respectively.

Also in the solar cell 102, the same effect as that of the solar cell 101 is provided.

In addition, the solar cell 102 has the hole transport layer 6 between the second layer 12 and the second electrode 34. For this reason, the second electrode 34 does not have to have the electron block property that the electrons migrating from the second perovskite compound are blocked. Therefore, the range of the choice of the material of the second electrode 34 is expanded.

The solar cell 102 can be fabricated in the same way as that of the solar cell 101. The hole transport layer is formed on the photoabsorber layer, for example, by an application method.

Hereinafter, each constituent elements of the solar cell 102 will be described specifically.

### (First electrode 32 and Second Electrode 34)

Since the hole transport layer 6 is used in the present embodiment, the second electrode 34 does not have to have the electron block property that the electrons migrating from the second perovskite compound are blocked. In other words, a material of the second electrode 34 may be a material capable of being in contact with the second perovskite compound. Therefore, the second electrode 34 can be formed so as to be light-transmissive.

At least one electrode of the first electrode 32 and the second electrode 34 may be light-transmisive. The first electrode 32 and the second electrode 34 may be configured similarly to the first electrode 2 in the first embodiment. One of the first electrode 32 and the second electrode 34 does not have to be light-transmisive. In this case, the electrode which is not light-transmisive does not have to have a region in which an electrode material is absent.

### (Substrate 31)

The substrate 31 may have the same configuration as the substrate 1 according to the first embodiment. When the second electrode 34 is light-transmissive, the substrate 31 can be formed of a material which is not light-transmissive. An example of the material which is not light-transmissive is a metal, a ceramic, or a resin material having a small light-transmissivity.

### (Hole transport layer 6)

The hole transport layer 6 is composed of, for example, an organic semiconductor or an inorganic semiconductor. The hole transport layer 6 may formed by stacking the same configuration material, or by stacking different materials alternately.

An example of the organic semiconductor is a compound including tertiary amine in the skeleton thereof or a compound including a thiophene structure. An example of the compound including tertiary amine in the skeleton thereof is phenylamine or triphenylamine. An example of the compound including a thiophene structure is PEDOT. The molecular weight of the organic semiconductor is not limited. The organic semiconductor may be a polymer. In a case where the hole transport layer 6 is formed of the organic semiconductor, the thickness of the hole transport layer 6 may be not less than 1 nanometer and not more than 1,000 nanometers, or may be not less than 100 nanometers and not more than 500 nanometers. If the thickness of the hole transport layer 6 falls within this range, sufficient hole transport property is exhibited. In addition, if the thickness of the hole transport layer 6 falls within this range, low resistance is maintained. Therefore, photovoltaics is conducted with high efficiency in the solar cell 102.

An example of the inorganic semiconductor is a p-type inorganic semiconductor. An example of the p-type inorganic semiconductor is CuO, Cu₂O, CuSCN, molybdenum oxide, or nickel oxide. In a case where the hole transport layer 6 is formed of the inorganic semiconductor, the thickness of the hole transport layer 6 may be not less than 1 nanometer and not more than 1,000 nanometers, or may be not less than 10 nanometers and not more than 50 nanometers. If the thickness of the hole transport layer 6 falls within this range, sufficient hole transport property is exhibited. In addition, if the thickness of the hole transport layer 6 falls within this range, low resistance is maintained. Therefore, photovoltaics is conducted with high efficiency in the solar cell 102.

An example of the formation method of the hole transport layer 6 is an application method or a printing method. An example of the application method is a doctor-blade method, a bar-coating method, a spraying method, a dip-coating method, or a spin-coating method. An example of the printing method is a screen-printing method. In addition, if necessary, a plurality of materials may be mixed, and then, pressured or sintered, to fabricate the hole transport layer 6. If the material of the hole transport layer 6 is an organic low molecular material or an inorganic semiconductor, the hole transport layer 6 can be fabricated by, for example, a vacuum vapor deposition method.

The hole transport layer 6 may contain a supporting electrolyte and a solvent. The supporting electrolyte and the solvent stabilize the holes included in the hole transport layer 6.

An example of the supporting electrolyte is an ammonium salt or an alkali metal salt. An example of the ammonium salt is tetrabutylammonium perchlorate, tetraethylammonium hexafluorophosphate, an imidazolium salt, or a pyridinium salt. An example of the alkali metal salt is lithium perchlorate or potassium tetrafluoroborate.

The solvent contained in the hole transport layer 6 may have high ionic conductivity. Examples of the solvent contained in the hole transport layer 6 is water and an organic solvent. If the organic solvent is used as the solvent contained in the hole transport layer 6, the solvent is stabilized more. An example of the organic solvent is a heterocyclic compound solvent. An example of the heterocyclic compound solvent is tert-butylpyridine, pyridine, or n-methylpyrrolidone.

In addition, as a solvent, an ionic liquid may be used solely. Alternatively, as a solvent, a mixture of an ionic liquid and another solvent may be used. The ionic liquid has advantages of its low volatility and high fire retardancy.

An example of the ionic liquid is an imidazolium-type ionic liquid, a pyridine-type ionic liquid, an alicyclic amine-type ionic liquid, an aliphatic amine-type ionic liquid, or an azonium amine-type ionic liquid. An example of the imidazolium-type ionic liquid is 1-ethyl-3-methylimidazolium tetracyanoborate.

Note that the configuration of the solar cell according to the present embodiment is not limited to the example shown in FIG. 5. For example, the first electrode 32 may serve as the positive electrode and the second electrode 34 may serve as the negative electrode. In this case, the hole transport layer 6 is disposed between the first electrode 32 and the first layer 11, and the electron transport layer 5 is disposed between the second electrode 34 and the second layer 12.

### EXAMPLES

Hereinafter, the solar cell according to the present disclosure will be described specifically with reference to the examples. In the examples, the solar cells according to the inventive examples 1 - 6 and the comparative example 1.

### (Inventive example 1)

The solar cell according to the inventive example 1 has the substantially same configuration as the solar cell 100 shown in FIG. 1. The constituent elements in the solar cell according to the inventive example 1 are listed below.
Substrate: Glass substrate, thickness: 0.7 millimeters
First electrode: Transparent electrode, Indium-tin-composite oxide layer
First layer: CH₃NH₃PbI₃, thickness: 300 nanometers
Second layer: CH(NH₂)₂PbI₃, thickness: 5,000 nanometers
Second electrode: Au, thickness: 80 nanometers
The solar cell according to the inventive example 1 was fabricated as below.

First, the ground substrate 10 having a transparent conductive layer, which served as the first electrode, on the surface thereof was prepared. In the present example, as the ground substrate 10, a conductive glass substrate (surface resistance: 10 ohm/sq., product of Nippon Sheet Glass Company, Ltd) having a thickness of 0.7 millimeters and having an indium-tin composite oxide layer on the surface thereof was prepared.

Next, as the first solution 51, a dimethylsulfoxide solution containing lead iodide (PbI₂) at a molar concentration of 1 mol/L and methylammonium iodide (CH₃NH₃I) at a molar concentration of 1 mol/L was prepared. Then, as shown in FIG. 3A, the first solution 51 was applied to the ground substrate 10 by a spin-coating method. At this time, a droplet of 200 microliters of chlorobenzene was put down to the rotating ground substrate 10.

Then, as shown in FIG. 3B, the ground substrate was heated on a hot plate at a temperature of 100 degrees Celsius to form the first layer 11 on the ground substrate 10.

Subsequently, as the second solution 52, γ-butyrolactone (GBL) solution containing PbI₂ at a molar concentration of 1 mol/L and formamidinium iodide (CH(NH₂)₂I) at a molar concentration of 1 mol/L was fabricated.

Then, each of the second solution 52 and the ground substrate 10 on which the first layer 11 was formed was heated to 100 degrees Celsius. Then, as shown in FIG. 3C, the ground substrate 10 heated to 100 degrees Celsius was immersed in the second solution 52 heated to 100 degrees Celsius, and then, was left at rest for 20 seconds. In this way, the second layer 12 was formed on the first layer 11. In this way, as shown in FIG. 3D, the photoabsorber layer 3 having a stacking structure was provided.

Then, an Au film having a thickness of 80 nanometers was deposited, on the second layer 12, by vacuum vapor deposition to form the second electrode. In this way, the solar cell according to the inventive example 1 was provided.

### (Inventive example 2)

In the inventive example 2, the solar cell was fabricated in the similar way to the inventive example 1, except that a droplet of chlorobenzene was not put down when the first layer 11 was formed by a spin-coating method.

### (Inventive example 3)

In the inventive example 3, the solar cell was fabricated in the similar way to the inventive example 2, except for the following two matters. First, as the first solution 51 used to form the first layer 11, a N,N-dimethylformamide (DMF) solution containing PbI₂ at a molar concentration of 0.5 mol/L and CH₃NH₃I at a molar concentration of 1.5 mol/L was used. Second, the first solution 51 was heated on the hot plate at a temperature of 170 degrees Celsius after the first solution 51 was applied to the ground substrate 10.

### (Inventive example 4)

The solar cell according to the inventive example 4 is different from the solar cell according to the inventive example 3 in that the first layer 11 contains CH₃NH₃PbBr₃ as the first perovskite compound. In the inventive example 4, as the first solution 51 used to form the first layer 11, a dimethylsulfoxide solution containing PbBr₂ at a molar concentration of 1 mol/L and methylammonium bromide (CH₃NH₃IBr) at a molar concentration of 1 mol/L was fabricated. The solar cell was fabricated in the similar way to the inventive example 3, except that the first solution 51 was different.

### (Inventive example 5)

The solar cell according to the inventive example 5 is different from the solar cell according to the inventive example 2 in that the second layer 12 contains CH₃NH₃PbI₃ as the second perovskite compound. In other words, in the inventive example 5, the compositions of the first perovskite compound and the second perovskite compound are same as each other. In the inventive example 5, as the second solution 52 used to form the second layer 12, a dimethylsulfoxide solution containing PbI₂ at a molar concentration of 1 mol/L and methylammonium Iodide (CH₃NH₃I) at a molar concentration of 1 mol/L was fabricated. The solar cell was fabricated in the similar way to the inventive example 2, except that the second solution 52 was different.

### (Comparative example 1)

The solar cell according to the comparative example 1 has the same configuration as the solar cell according to the inventive example 1, except that the solar cell according to the comparative example 1 does not have the second layer 12. The fabrication method of the solar cell according to the comparative example 1 is the same as that of the inventive example 1, except that the second layer 12 is not formed.

### (Composition analysis)

In order to investigate the composition of the perovskite compounds of the first layer 11 and the second layer 12 in the inventive example 1, a RBS/NRA (Rutherford backscattering spectroscopy / nucleus reaction analysis method) composition analysis was conducted. Here, a sample for analysis in which only the first layer 11 was formed on the ground substrate 10 was fabricated to conduct the composition analysis of the first layer 11. In addition, a sample for analysis in which only the first layer 11 and the second layer 12 were formed on the ground substrate 10 was fabricated to conduct the composition analysis of the second layer 12.

The analysis results are shown in Table 1. In Table 1, element ratios of each of the compound to Pb are shown.

**[Table 1]**

| | Element ratio of iodine I/Pb | Element ratio of carbon C/Pb |
|---|---|---|
| First layer (CH₃NH₃PbI₃) | 2.96 | 1.05 |
| Second layer (CH(NH₂)₂PbI₃) | 2.99 | 1 |

From the results shown in Table 1, it was confirmed that each of the first layer 11 and the second layer 12 contains a perovskite compound having a composition of A:M:X=1:1:3.

### (Crystal Structure Analysis)

Then, XRD measurements of the first layer 11 and the second layer 12 in the solar cells according to the inventive examples 1 - 5 and the comparative example 1 were conducted. As the X-ray, a CuKa was used. In each of the examples, the sample for analysis in which only the first layer 11 was formed on the ground substrate 10 was fabricated to conduct the XRD measurement of the first layer 11. In addition, a sample for analysis in which only the first layer 11 and the second layer 12 were formed on the ground substrate 10 was fabricated to conduct the XRD measurement of the second layer 12.

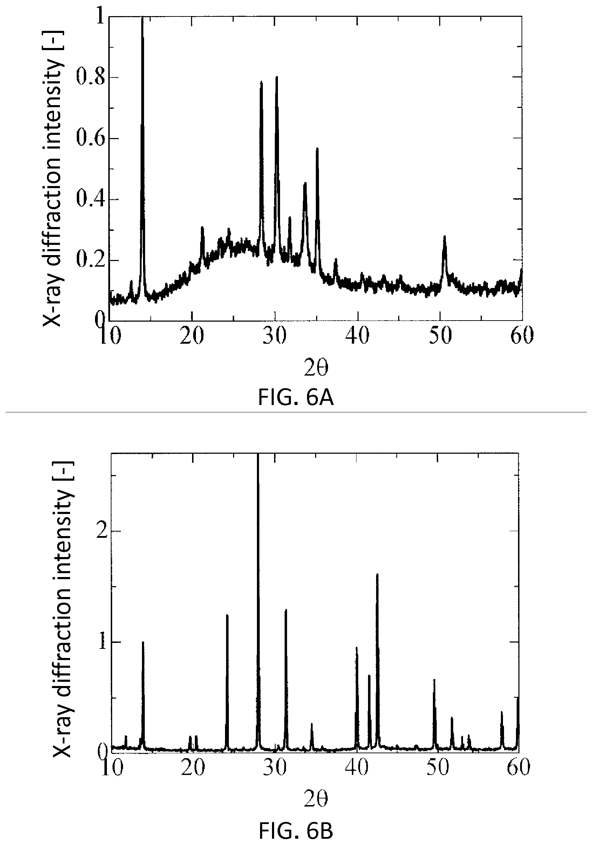

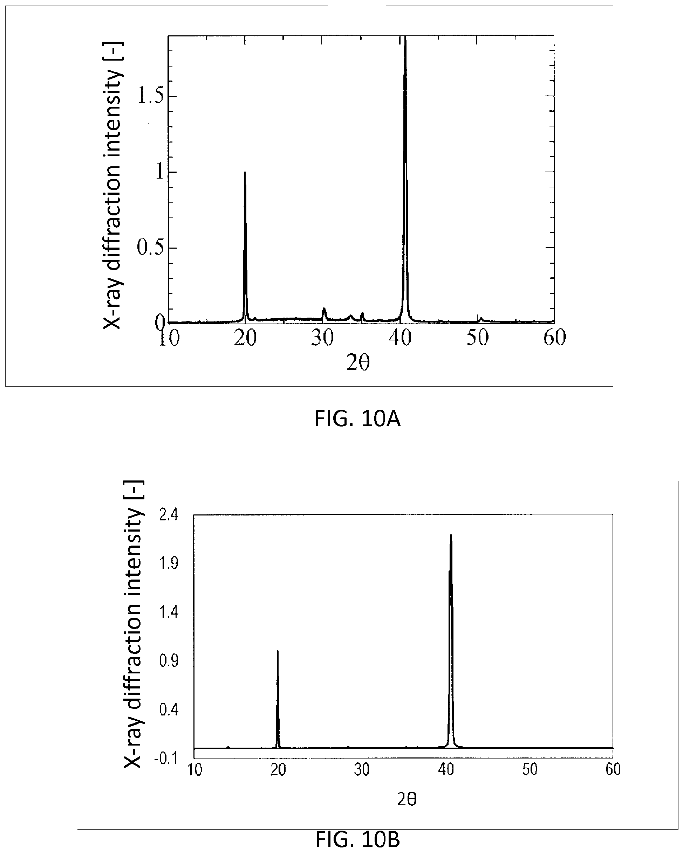

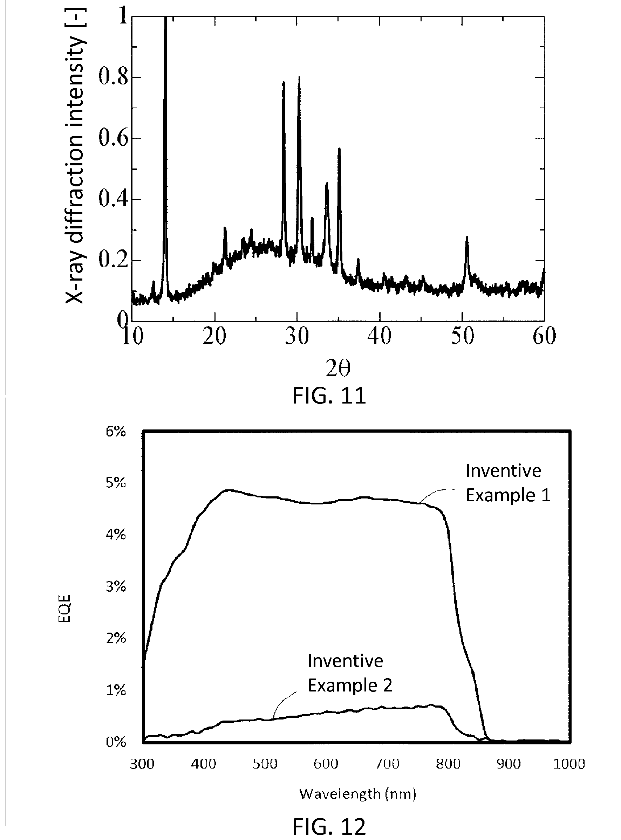

FIG. 6A is a drawing showing the XRD measurement result of the first layer 11 in the inventive example 1. FIG. 6B is a drawing showing the XRD measurement result of the second layer 12 in the inventive example 1. Likewise, FIG. 7A and FIG. 7B - FIG. 10A and FIG. 10B are drawings showing the XRD measurement results of the first layer 11 and the second layer 12 in the inventive examples 2 - 5, respectively. In addition, FIG. 11 is a drawing showing the XRD measurement result of the photoabsorber layer in the comparative example 1. In each of the drawings showing the XRD measurement results, the horizontal axis represents an angle 2θ, and the vertical axis represents an X-ray diffraction intensity.

On the basis of the XRD measurements results with regard to the first layer 11 and the second layer 12 in the inventive examples 1 - 5, the investigation results of the orientations of the layers are collectively shown in Table 2. In Table 2, if a layer has a single orientation, the direction thereof is shown.

From this result, in each of the inventive examples, it is confirmed that the second layer 12 has an orientation which reflects the crystal orientation of the first layer 11. For example, in the inventive example 1, if the orientation of the first layer 11 is low, the orientation of the second layer 12 is also low. In addition, for example, in the inventive examples 2 - 3, if the orientations of the crystal are aligned in the first layer 11, it is understood that the second layer 12 in which the orientations of the crystals are aligned and which has the same orientation as the first layer 11 is formed.

Hereinafter, the XRD measurement results will be described in more detail in each of the inventive examples.

From FIG. 6A and FIG. 6B, it is understood that each of the first layer 11 and the second layer 12 in the inventive example 1 does not have a single orientation. It is believed that the reason why the orientation of the first layer 11 is low is that the droplet of chlorobenzene was put down during the spin coat of the first solution 51 to form fine crystals of the first perovskite compound randomly in the chlorobenzene. In FIG. 6A, since the peak intensity is low, the change of the intensity of background is observed. However, this does not relate to the characteristic of the photoabsorber layer.

As shown in FIG. 7A and FIG. 7B, the X-ray diffraction patterns of the first layer 11 and the second layer 12 in the inventive example 2 have a peak p1 and a peak p2, both of which are located near 2θ=20°, respectively. Both of the peak p1 and the peak p2 are attributed to a (110) plane. In addition, the intensity of both the peak p1 and the peak p2 is ten or more times as much as the maximum value of the intensity within the first range. Therefore, each of the first layer 11 and the second layer 12 in the inventive example 2 has a single orientation. In addition, each of the first layer 11 and the second layer 12 has a (110) orientation. Therefore, the first layer 11 and the second layer 12 have the same orientation as each other. In the inventive example 2, a droplet of chlorobenzene was not put down during the spin coat of the first solution 51. For this reason, it was believed that the first layer 11 in which the orientation was aligned was formed since an original point of the crystal generation was limited to the interface of the first solution 51 and the air.

As shown in FIG. 8A and FIG. 8B, the X-ray diffraction patterns of the first layer 11 and the second layer 12 in the inventive example 3 have a peak p3 and a peak p4, both of which are located near 2θ=14°, respectively. Both of the peak p3 and the peak p4 are attributed to a (100) plane. In addition, the intensity of both the peak p3 and the peak p4 is ten or more times as much as the maximum value of the intensity within the second range. Therefore, each of the first layer 11 and the second layer 12 in the inventive example 3 has a single orientation. In addition, each of the first layer 11 and the second layer 12 in the inventive example 3 has a (100) orientation. Therefore, the first layer 11 and the second layer 12 have the same orientation as each other. In the inventive example 3, a droplet of chlorobenzene was not put down during the spin coat of the first solution 51. For this reason, it was believed that the first layer 11 in which the orientation was aligned was formed for the reason mentioned in the inventive example 2.

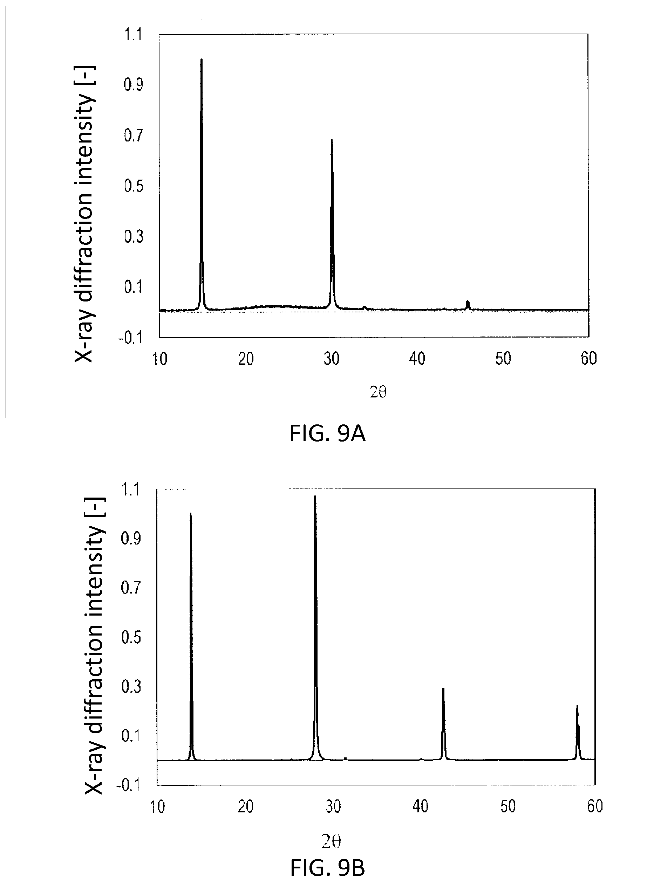

In the inventive example 4, as shown in FIG. 9A and FIG. 9B, the X-ray diffraction patterns of the first layer 11 and the second layer 12 have peaks located near 2θ=14°, respectively. These peaks are attributed to a (100) plane. In addition, the intensity of these peaks is ten or more times as much as the maximum value of the intensity within the second range. Therefore, each of the first layer 11 and the second layer 12 in the inventive example 4 has a single orientation. In addition, each of the first layer 11 and the second layer 12 in the inventive example 4 has a (100) orientation. Therefore, the first layer 11 and the second layer 12 have the same orientation as each other. In the inventive example 4, a droplet of chlorobenzene was not put down during the spin coat of the first solution 51. For this reason, it was believed that the first layer 11 in which the orientation was aligned was formed for the reason mentioned in the inventive examples 2 and 3.

In the inventive example 5, as shown in FIG. 10A and FIG. 10B, the X-ray diffraction patterns of the first layer 11 and the second layer 12 have peaks located near 2θ=20°, respectively. These peaks are attributed to a (110) plane. In addition, the intensity of these peaks is ten or more times as much as the maximum value of the intensity within the first range. Therefore, each of the first layer 11 and the second layer 12 in the inventive example 5 has a single orientation. In addition, each of the first layer 11 and the second layer 12 in the inventive example 5 has a (110) orientation. Therefore, the first layer 11 and the second layer 12 have the same orientation as each other. In the inventive example 5, a droplet of chlorobenzene was not put down during the spin coat of the first solution 51. For this reason, it was believed that the first layer 11 in which the orientation was aligned was formed for the reason mentioned in the inventive examples 2, 3, and 4.

Note that the X-ray diffraction pattern in the photoabsorber layer of the comparative example 1 is the same as that of the first layer 11 of the inventive example 1, as shown in FIG. 11.

As just described, regardless of the composition of the perovskite compound, it was confirmed that the photoabsorber layer having a stacking structure is formed by precipitating the second layer 12 on the first layer 11.

### (Measurement of short-circuit current density)

The electric current value which flowed when the solar cells according to the inventive examples 1 - 5 and the comparative example 1 were irradiated with light having a single wavelength was measured, while the wavelength was changed from 400 nanometers to 1,000 nanometers. From these results, the quantum efficiency of the solar cells was calculated, and the short-circuit current density (mA/cm²) was measured. The results are shown collectively in Table 2.

**[Table 2]**

| | First layer (Seed layer) | | Second layer | | Short-circuit current density |
|---|---|---|---|---|---|
| | Material (First perovskite compound) | Orientation (Plane orientation) | Material (Second perovskite compound) | Orientation (Plane orientation) | |
| Inventive Example 1 | CH₃NH₃PbI₃ | - | CH(NH₂)₂PbI₃ | - | 3 |
| Inventive Example 2 | CH₃NH₃PbI₃ | (110) | CH(NH₂)₂PbI₃ | (110) | 15 |
| Inventive Example 3 | CH₃NH₃PbI₃ | (100) | CH(NH₂)₂PbI₃ | (100) | 12 |
| Inventive Example 4 | CH₃NH₃PbBr₃ | (100) | CH(NH₂)₂PbI₃ | (100) | 15 |
| Inventive Example 5 | CH₃NH₃PbI₃ | (110) | CH₃NH₃PbI₃ | (110) | 0.6 |
| Comparative Example 1 | CH₃NH₃PbI₃ | - | None | - | 0.1 |

From the results shown in Table 2, it is confirmed that the solar cells according to the inventive examples 1 - 5 each having the photoabsorber layer in which the first layer 11 and the second layer 12 are stacked has higher short-circuit current density than the solar cell according to the comparative example 1.

In addition, the solar cell according to the inventive examples 1 - 4 in which the compositions of the first perovskite compound and the second perovskite compound are different from each other has higher short-circuit current density than the solar cell according to the inventive example 5 in which the compositions of the first perovskite compound are the second perovskite compound are the same as each other. It is believed that this is because, as above described, the recombination of the carriers generated in the photoabsorber layer is prevented using the difference of the energy levels of the valence bands and the conduction bands of the first perovskite compound and the second perovskite compound.

Among the solar cells according to the inventive examples 1 - 4, the solar cells according to the inventive examples 2 - 4 in which the first layer 11 and the second layer 12 have the same orientation as each other have higher short-circuit current density than the solar cell according to the inventive example 1 in which the orientations of the first layer 11 and the second layer 12 are low. It is believed that this is because, as above described, the carriers migrate easily in the photoabsorber layer 3 if the first layer 11 and the second layer 12 in the photoabsorber layer 3 are aligned.

From these results, it is understood that the short-circuit current density of the solar cell is improved more by forming the photoabsorber layer with two perovskite layers and by controlling the composition and orientation of the perovskite compound in each of the layers.

### (Measurement of external quantum efficiency)

The external quantum efficiency (EQE) of the solar cells according to the inventive examples 1 and 2 was measured. The results are shown in FIG. 12. The horizontal axis in FIG. 12 represents a wavelength of the incident light, and the vertical axis represents the external quantum efficiency.

From this result, in the wavelength region of visible light, the solar cell according to the inventive example 2 in which the first layer 11 and the second layer 12 have the same orientation as each other has higher external quantum efficiency than the solar cell according to the inventive example 1 in which the orientations of the first layer 11 and the second layer 12 are low.

The compositions of the first perovskite compound and the second perovskite compound are not limited to the compositions described in the above examples. For example, by a method similar to that of the above example, the second layer containing at least one kind of CH₃NH₃PbI₃ and CH₃NH₃PbBr₃ can be formed on the first layer containing CH(NH₂)₂PbI₃. In addition, for example, the second layer containing at least one kind of CH(NH₂)₂PbI₃, CH₃NH₃PbI₃, and CH₃NH₃PbBr₃ can be formed on the first layer containing CH₃NH₃PbBr₃.

In all of the above examples, the photoabsorber layer was formed directly on the transparent conductive layer which served as the negative electrode; however, the layer which is an underlayer of the photoabsorber is not limited. For example, the photoabsorber layer may be formed on the electrode which serves as the positive electrode. Alternatively, after the carrier transport layer is formed on the electrode, the photoabsorber layer may be formed on the carrier transport layer. The photoabsorber layer can be formed on another electrode layer or the carrier transport layer by a method similar to that of the above example.

### INDUSTRIAL APPLICABILITY

The solar cell according to the embodiments of the present disclosure is used widespread as a device for electric power generation system converting light such as sunlight or artificial illumination light into electric power. On the other hand, the solar cell according to the embodiments of the present disclosure may be applied to a light sensor such as a photodetector or an image sensing from the function converting the light into electric power.

### REFERENTIAL SIGNS LIST

- 1: Substrate
- 2: First Electrode
- 3: Photoabsorber Layer
- 4: Second Electrode
- 5: Electron Transport Layer
- 6: Hole Transport Layer
- 11: First layer
- 12: Second layer
- 100, 101, 102: Solar Cell

## Claims

1. A solar cell comprising:
a first electrode;
a second electrode opposite to the first electrode;
a photoabsorber layer located between the first electrode and the second electrode and including a first layer and a second layer,
wherein
the first layer contains a first compound which has a perovskite structure represented by the composition formula A¹M¹X¹₃, where A¹ is a monovalent cation, M¹ is a divalent cation, and X¹ is a halogen anion;
the second layer contains a second compound which has a perovskite structure represented by the composition formula A²M²X²₃, where A² is a monovalent cation, M² is a divalent cation, and X² is a halogen anion, and has a different composition from the first compound; and
at least one of the first compound in the first layer and the second compound in the second layer has a single orientation.

2. The solar cell according to Claim 1, wherein
in the first layer, the first compound has a single orientation; and
in the second layer, the second compound has a single orientation.

3. The solar cell according to Claim 1 or 2, wherein
the orientation of the first compound and the orientation of the second compound are aligned.

4. The solar cell according to any one of Claims 1 to 3, wherein
in an X-ray diffraction pattern of the first layer using an CuKa ray, a first peak is present within a range of a diffraction angle of not less than 18° and not more than 23°;
a diffraction intensity of the first peak is ten or more times as much as a maximum value of an diffraction intensity within a range of a diffraction angle of not less than 13° and not more than 16°;
in an X-ray diffraction pattern of the second layer using an CuKa ray, a second peak is present within a range of a diffraction angle of not less than 18° and not more than 23°;
a diffraction intensity of the second peak is ten or more times as much as a maximum value of an diffraction intensity within a range of a diffraction angle of not less than 13° and not more than 16°.

5. The solar cell according to any one of Claims 1 to 3, wherein
in an X-ray diffraction pattern of the first layer using an CuKa ray, a first peak is present within a range of a diffraction angle of not less than 13° and not more than 16°;
a diffraction intensity of the first peak is ten or more times as much as a maximum value of an diffraction intensity within a range of a diffraction angle of not less than 18° and not more than 23°;
in an X-ray diffraction pattern of the second layer using an CuKa ray, a second peak is present within a range of a diffraction angle of not less than 13° and not more than 16°;
a diffraction intensity of the second peak is ten or more times as much as a maximum value of an diffraction intensity within a range of a diffraction angle of not less than 18° and not more than 23 °.

6. The solar cell according to any one of Claims 1 to 5, further comprising:
a first carrier transport layer between the first electrode and the first layer.

7. The solar cell according to Claim 6, wherein
the first electrode is a negative electrode;
the second electrode is a positive electrode; and
the first carrier transport layer is an electron transport layer.

8. The solar cell according to Claim 6 or 7, further comprising:
a second carrier transport layer between the second electrode and the second layer.

9. The solar cell according to Claim 8, wherein
the first electrode is a negative electrode;
the second electrode is a positive electrode; and
the second carrier transport layer is a hole transport layer.

10. The solar cell according to any one of Claims 1 to 9, wherein
a thickness of the first layer is one-fourth or less times as much as a thickness of the second layer.

11. The solar cell according to any one of Claims 1 to 10, wherein
in the first compound, A¹ is CH₃NH₃⁺ and B¹ is Pb²⁺; and
in the second compound, A² is NH₂CHNH₂⁺ and B² is Pb²⁺.

12. A photoabsorber layer comprising:
a first layer containing a first compound which has a perovskite structure represented by the composition formula A¹M¹X¹₃, where A¹ is a monovalent cation, M¹ is a divalent cation, and X¹ is a halogen anion; and
a second layer containing a second compound which has a perovskite structure represented by the composition formula A²M²X²₃, where A² is a monovalent cation, M² is a divalent cation, and X² is a halogen anion, and has a different composition from the first compound,
wherein
at least one of the first compound in the first layer and the second compound in the second layer has a single orientation.

13. The photoabsorber layer according to Claim 12, wherein
in the first layer, the first compound has a single orientation; and
in the second layer, the second compound has a single orientation.

14. The photoabsorber layer according to Claim 12 or 13, wherein
the orientation of the first compound and the orientation of the second compound are aligned with each other.

15. A formation method of a photoabsorber layer, the method comprising:
(A) disposing a first solution containing a monovalent cation A¹, a divalent cation M¹, and a halogen anion X¹ on a substrate, and then, drying the first solution, to form a first layer containing a first compound which has a perovskite structure represented by the composition formula A¹M¹X¹₃ and has a single orientation; and
(B) disposing a second solution containing a monovalent cation A², a divalent cation M², and a halogen anion X² on the first layer, and then, drying the second solution, to form, on the first layer, a second layer containing a second compound which has a perovskite structure represented by the composition formula A²M²X²3 , has a single orientation, and is different from the first compound.

16. The formation method of the photoabsorber layer according to Claim 15, wherein the second solution contains a lactone solvent.

17. The formation method of the photoabsorber layer according to Claim 15 or 16, wherein
In the step of (B), the substrate is heated to a temperature at which the second solution is in a saturated or oversaturated state, and then, the heated substrate is immersed in the second solution.
